# EUROPEAN PATENT APPLICATION

(11) **EP 4 322 209 A1**
(43) Date of publication of application: **14.02.2024**
(21) Application number: 22783845.5
(22) Date of filing: 14.03.2022
(51) Int. Cl.: H01L 23/34, G01K 7/01

(54) **HIGH-SENSITIVITY TEMPERATURE SENSOR IN WHICH SILICON CARBIDE CAN BE INTEGRATED**

(30) Priority: 08.04.2021 CN 202110374953
(71) Applicant: Novus Semiconductors Co., Ltd., Chengdu, Sichuan 610096 (CN)
(72) Inventor: GU, Hang, Sichuan 614099 (CN); GAO, Wei, Beijing 100085 (CN); DAI, Maozhou, Chengdu 610095 (TW)
(74) Representative: Ipey
(86) International application number: PCT/CN2022/080557
(87) International publication number: WO 2022/213776

(57) **Abstract**

The present invention relates to a high-sensitivity temperature sensor in which silicon carbide can be integrated, and belongs to the technical field of power semiconductor devices. According to the temperature sensor of the present invention, voltage drops on an N-type semiconductor and a P-type semiconductor of silicon carbide are a positive temperature coefficient and a negative temperature coefficient, respectively, and thus the change rate of the difference in voltage drop on two electrodes following temperature is amplified. The temperature sensor of the present invention has a large temperature measurement range, has high temperature measurement sensitivity, can be integrated as a single chip in a silicon carbide power semiconductor, and is compatible in process. The described temperature sensor is electrically isolated from a main device by means of a P-type region, and the working states of the temperature sensor and the main device do not influence one another. In addition, the current in the P-type or N-type semiconductor is small, and thus the current in the N-type semiconductor and the current in the P-type semiconductor do not influence one another.

## Description

### BACKGROUND OF THE INVENTION

### 1. Technical Field

The invention belongs to the technical field of power semiconductor devices, and particularly relates to a high-sensitivity temperature sensor in which silicon carbide can be integrated.

### 2. Description of Related Art

Compared with Si materials, SiC wide-bandgap semiconductor materials, as ideal materials for preparing high-voltage power electronic devices, have the advantages of high breakdown electric field intensity (4*10⁶V/cm), high drift velocity (2*10⁷cm/s), high thermal conductivity, and good thermal stability, thus being particularly suitable for high-power, high-voltage, high-temperature and anti-radiation electronic devices.

SiC VDMOS is a device commonly used in SiC power devices, and compared with bipolar devices, the SiC VDMOS is free of the charge-storage effect, thus having better frequency characteristics and lower switching loss. Meanwhile, the wide bandgap of the SiC materials allows the operating temperature of the SiC VDMOS to be as high as 300°C.

However, the SiC VDMOS has a serious problem of low carrier mobility of the surface of the device, which is caused by a severe interfacial state of SiC and SiO₂ due to the existence of a large quantity of unsaturated bonds and other defects of the interface of SiC and SiO2, leading to an increase of the surface resistance (channel resistance), so power consumption generated in a channel may be as high as power consumption generated in a drift region. Because the SiC VDMOS generally works under a high current, the heat potential of the device is severe, and some properties of the device will be degraded or even disabled under excessively high temperature. Up to now, the main limitations of the SiC VDMOS are the packaging technology, the lack of temperature information about its safe operating range, and particularly the influence of temperature on the reliability of a gate oxide layer.

Technicians can obtain temperature information of the device by measuring the packaging temperature, but the internal temperature of the device is closely related to the resistance of all parts of the device, thus being different from the packaging temperature. Temperature sensors may be separately integrated in a package and a main device to monitor the temperature of the device; however, this method cannot obtain temperature information of the device most directly and rapidly, and temperature measured through this method is not targeted. If the channel resistance R_{ch} or the resistance R_{JFET} of the JFET region is large, power consumption of the surface of the device will be high, and the surface temperature will be high, which may reduce the reliability of the gate oxide of the device. So, a novel approach for monitoring the surface temperature of the device is urgently needed to obtain temperature information most rapidly and accurately.

### BRIEF SUMMARY OF THE INVENTION

In view of the problems of the prior art, the technical issue to be settled by the invention is to provide a high-sensitivity temperature sensor in which silicon carbide can be integrated to meet the requirements for testing the junction temperature power of semiconductors, under the background of inaccuracy and low sensitivity of temperature measurement of traditional temperature sensors.

To settle the above technical issue, one embodiment of the invention provides a high-sensitivity temperature sensor in which silicon carbide can be integrated, comprising a first PAD region 1, a second PAD region 2, a third PAD region 3, a P-type well region 4, an N-type well region 5, a first metal 6, a second metal 7, a third metal 8, a first ohmic contact region 9, a second ohmic contact region 10, and a third ohmic contact region 11;
The N-type well region 5 and the second ohmic contact region 10 are located in the P-type well region 4 in a spaced manner; the first ohmic contact region 9 is located in the N-type well region 5; the third ohmic contact region 11 is located in the P-type well region 4, and is connected to the P-type well region 4 and the N-type well region 5;
The third ohmic contact region 11 extends from the first metal 6 into the first PAD region 1, the first ohmic contact region 9 extends from the second metal 7 into the second PAD region 2, and the second ohmic contact region 10 extends from the third metal 8 into the third PAD region 3.

Based on the above technical solution, the invention may be improved in the following aspects.

Further, the P-type well region 4 is formed by aluminum ion implantation.

Further, the N-type well region 5 is formed by phosphorous ion implantation.

Further, a doping concentration of the P-type well region 4 is from 1e15cm-3 to 1e20cm-3, and/or, a doping concentration of the N-type well region 5 is from 1e15cm-3 to 1e19cm-3.

Further, an implantation depth of the P-type well region 4 is greater than that of the N-type well region 5.

Further, the second ohmic contact region 10 is formed by the same ion implantation as the P-type well region 4.

Further, a doping concentration of the second ohmic contact region 10 is from 1e18cm-3 to 1e21cm-3.

Further, the first ohmic contact region 9 is formed by the same ion implantation as the N-type well region 5.

Further, a doping concentration of the first ohmic contact region 9 is from 1e18cm-3 to 1e22cm-3.

Further, the first metal 6, the second metal 7 and the third metal 8 are aluminum.

Compared with the prior art, the invention has the following beneficial effects:
1. N-type implantation and P-type implantation may be synchronously completed with other process steps of a main device, so the temperature sensor can be integrated in a power semiconductor under a process-compatible condition;
2. The high-sensitivity temperature sensor in which silicon carbide can be integrated is fully electrically isolated from the main device through the P-type well region 4, so that the working state of the temperature sensor and the working state of the main device will not be affected by each other;
3. Under a certain doping concentration, the sensitivity of N-type silicon carbide and the sensitivity of P-type silicon carbide are fixed; the temperature sensor provided by the invention measures temperature by means of bulk resistors, connected in parallel, on the surface of the N-type silicon carbide and the surface of the P-type silicon carbide; a certain current is applied to the two resistor regions respectively, a voltage drop of the N-type silicon carbide is a positive temperature coefficient, and a voltage drop of the P-type silicon carbide is a negative temperature coefficient, so if a different between the voltage drops of the two resistors is used to represent temperature, the sensitivity of the temperature sensor is the sum of the sensitivity of the N-type silicon carbide and the sensitivity of the P-type silicon carbide, which is higher than the sensitivity of any one electrically conductive silicon carbide bulk resistor; therefore, the high-sensitivity temperature sensor in which silicon carbide can be integrated provided by the invention has high sensitivity, which is higher than the sensitivity of any silicon carbide temperature sensors using bulk resistors for temperature measurement.

### BRIEF DESCRIPTION OF THE SEVERAL VIEWS OF THE DRAWINGS

FIG. 1 is a structural view of a high-sensitivity temperature sensor in which silicon carbide can be integrated according to one embodiment of the invention;
FIG. 2 is a sectional view of the high-sensitivity temperature sensor in which silicon carbide can be integrated according to one embodiment of the invention;
FIG. 3 is an equivalent circuit diagram, namely a temperature measurement diagram, of the high-sensitivity temperature sensor in which silicon carbide can be integrated according to one embodiment of the invention.

Components represented by the reference signs in the figures:
1, first PAD region; 2, second PAD region; 3, third PAD region; 4, P-type well region; 5, N-type well region; 6, first metal; 7, second metal; 8, third metal; 9, first ohmic contact region; 10, second ohmic contact region; 11, third ohmic contact region; 12, sectional view of N-type well region; 13, top view of high-sensitivity temperature sensor in which silicon carbide can be integrated; 14, sectional view of P-type well region.

### DETAILED DESCRIPTION OF THE INVENTION

The principle and features of the invention will be described below in conjunction with the accompanying drawings. The embodiments illustrated below are merely used to explain the invention, and are not used to limit the scope of the invention.

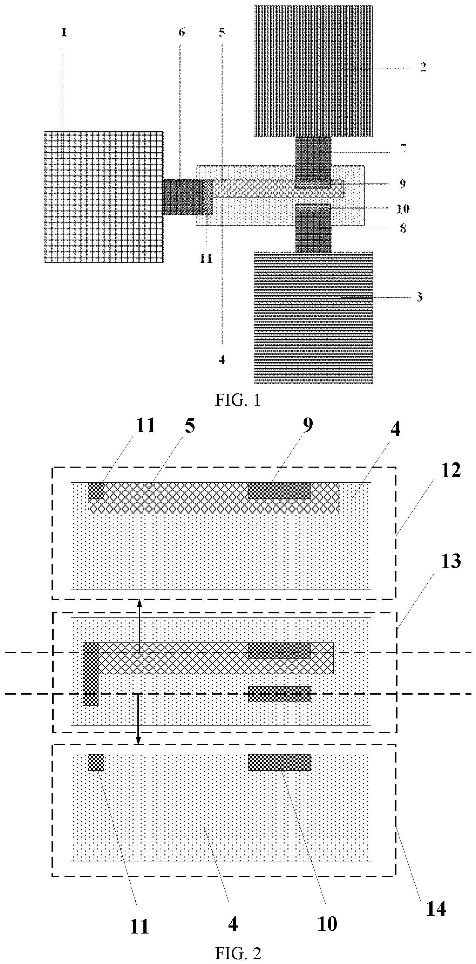

As shown in FIG. 1-FIG. 2, a first embodiment of the invention provides a high-sensitivity temperature sensor in which silicon carbide can be integrated, comprising a first PAD region 1, a second PAD region 2, a third PAD region 3, a P-type well region 4, an N-type well region 5, a first metal 6, a second metal 7, a third metal 8, a first ohmic contact region 9, a second ohmic contact region 10, and a third ohmic contact region 11;
The N-type well region 5 and the second ohmic contact region 10 are located in the P-type well region 4 in a spaced manner; the first ohmic contact region 9 is located in the N-type well region 5; the third ohmic contact region 11 is located in the P-type well region 4, and is connected to the P-type well region 4 and the N-type well region 5;
The third ohmic contact region 11 extends from the first metal 6 into the first PAD region 1, the first ohmic contact region 9 extends from the second metal 7 into the second PAD region 2, and the second ohmic contact region 10 extends from the third metal 8 into the third PAD region 3.

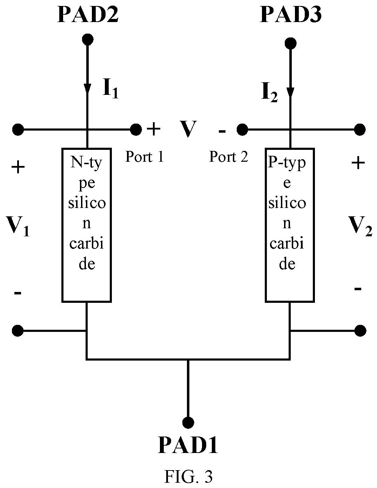

The working principle of the invention is as follows:
As shown in FIG. 3 which is an equivalent circuit diagram of the temperature sensor, when a constant small current I1 is applied to the second PAD region 2, N-type silicon carbide generates a voltage drop V1; when a constant small current I1 is applied to the third PAD region 3, P-type silicon carbide generates a voltage drop V2. Because the lattice scattering of the N-type silicon carbide will be aggravated with the increase of temperature, the migration rate will decrease, the resistance will increase, and V1 will increase with the increase of temperature.

In addition, impurities in the P-type silicon carbide will not be completely ionized at room temperature, the effective doping concentration of the P-type silicon carbide will be increased by the ionized impurities with the increase of temperature, the resistance will decrease, and V2 will decrease with the increase of temperature.

If the change rate of V1 with temperature is S1, S1=dV1/dT, and S1 is positive. If the change rate of V2 with temperature is S2, S2=dV2/dT, and S2 is negative. By testing the voltage across two terminals of a port 1 and a port 2, it can be obtained that V=V1-V2, the potential difference is in an approximately linear relationship with the temperature T. The operating temperature of the device can be obtained according to a fitting formula T=a*V+b after fitting calibration, where a and b are fitting parameters. The sensitivity of the temperature sensor meets S=dV/dT=S1-S2=|S1|+|S2|, and is the sum of the sensitivity of two semiconductor regions.

Optionally, the P-type well region 4 is formed by aluminum ion implantation.

Optionally, the N-type well region 5 is formed by phosphorous ion implantation.

Optionally, a doping concentration of the P-type well region 4 is from 1e15cm-3 to 1e20cm-3, and/or, a doping concentration of the N-type well region 5 is from 1e15cm-3 to 1e19cm-3.

Optionally, an implantation depth of the P-type well region 4 is greater than that of the N-type well region 5.

Optionally, the second ohmic contact region 10 is formed by the same ion implantation as the P-type well region 4.

Optionally, a doping concentration of the second ohmic contact region 10 is from 1e18cm-3 to 1e21cm-3 .

Optionally, the first ohmic contact region 9 is formed by the same ion implantation as the N-type well region 5.

Optionally, a doping concentration of the first ohmic contact region 9 is from 1e18cm-3 to 1e22cm-3.

Optionally, the first metal 6, the second metal 7 and the third metal 8 are aluminum.

The temperature sensor of the invention is provided with three electrodes, wherein a first electrode formed by the first PAD region covers the P-type region and the N-type region, a second electrode formed by the second PAD region is connected to the P-type region, and a third electrode formed by the third PAD region is connected to the N-type region. The first electrode of the temperature sensor is generally in short connection with a source or cathode of a main device, and when a small current is applied to the second electrode and the third electrode, a voltage difference between the second electrode and the third electrode is in an approximately linear relationship, and the operating temperature of a device can be represented by testing the voltage difference between the second electrode and the third electrode through fitting calibration. Because voltage drops on the N-type silicon carbide semiconductor and the P-type silicon carbide semiconductor are a positive temperature coefficient and a negative temperature coefficient, respectively, and thus, the change rate of the difference in voltage drop on two electrodes following temperature is amplified. The temperature sensor has a large temperature measurement range, has high temperature measurement sensitivity, can be integrated as a single chip in a silicon carbide power semiconductor alone, and is compatible in process. According to the temperature sensor, a P-type region is electrically isolated from a main device, so that the working states of the temperature sensor and the main device do not influence one another. In addition, the current of the P-type or N-type semiconductor is small, and thus the current in the N-type semiconductor and the current in the P-type semiconductor do not influence one another.

In the description of the invention, terms such as "first" and "second" are merely used for a descriptive purpose, and should not be construed as indicating or implying relative importance, or implicitly indicating the number of technical features referred to. Therefore, a feature defined by "first" or second" may explicitly or implicitly indicate the inclusion of at least one said feature. In the description of the invention, "multiple" refers to at least two, such as three, unless otherwise specifically and clearly defined.

In the description of the invention, the description of the reference terms such as "one embodiment", "some embodiments", "example", "specific example", and "some examples" indicates that the specific characteristics, structures, materials or features described in conjunction with the embodiment or example are included in at least one embodiment or example of the invention. In this specification, illustrative descriptions of these terms do not necessarily refer to identical embodiments or examples. In addition, the specific characteristics, structures, materials or features in the description may be combined properly in one or more embodiments or examples. Moreover, those skilled in the art may integrate or combine different embodiments or examples described in this specification, or the features of different embodiments or examples without mutual contradiction.

The foregoing description is merely used to explain preferred embodiments of the invention, and is not used to limit the invention. Any amendments, equivalent substitutions and improvements made based on the spirit and principle of the invention should fall within the protection scope of the invention.

## Claims

1. A high-sensitivity temperature sensor in which silicon carbide can be integrated, comprising a first PAD region (1), a second PAD region (2), a third PAD region (3), a P-type well region (4), an N-type well region (5), a first metal (6), a second metal (7), a third metal (8), a first ohmic contact region (9), a second ohmic contact region (10), and a third ohmic contact region (11);
the N-type well region (5) and the second ohmic contact region (10) are located in the P-type well region (4) in a spaced manner; the first ohmic contact region (9) is located in the N-type well region (5); the third ohmic contact region (11) is located in the P-type well region (4), and is connected to the P-type well region (4) and the N-type well region (5);
the third ohmic contact region (11) extends from the first metal (6) into the first PAD region (1), the first ohmic contact region (9) extends from the second metal (7) into the second PAD region (2), and the second ohmic contact region (10) extends from the third metal (8) into the third PAD region (3).

2. The high-sensitivity temperature sensor in which silicon carbide can be integrated according to Claim 1, wherein the P-type well region (5) is formed by aluminum ion implantation.

3. The high-sensitivity temperature sensor in which silicon carbide can be integrated according to Claim 1, wherein the N-type well region (5) is formed by phosphorous ion implantation.

4. The high-sensitivity temperature sensor in which silicon carbide can be integrated according to Claim 1, wherein a doping concentration of the P-type well region (4) is from 1e15cm-3 to 1e20cm-3, and/or, a doping concentration of the N-type well region (5) is from 1e15cm-3 to 1e19cm-3.

5. The high-sensitivity temperature sensor in which silicon carbide can be integrated according to Claim 1, wherein an implantation depth of the P-type well region (4) is greater than that of the N-type well region (5).

6. The high-sensitivity temperature sensor in which silicon carbide can be integrated according to Claim 1, wherein the second ohmic contact region (10) is formed by the same ion implantation as the P-type well region (4).

7. The high-sensitivity temperature sensor in which silicon carbide can be integrated according to Claim 1, wherein a doping concentration of the second ohmic contact region (10) is from 1e18cm-3 to 1e21cm-3.

8. The high-sensitivity temperature sensor in which silicon carbide can be integrated according to Claim 1, wherein the first ohmic contact region (9) is formed by the same ion implantation as the N-type well region (5).

9. The high-sensitivity temperature sensor in which silicon carbide can be integrated according to Claim 1, wherein a doping concentration of the first ohmic contact region (9) is from 1e18cm-3 to 1e22cm-3.

10. The high-sensitivity temperature sensor in which silicon carbide can be integrated according to Claim 1, wherein the first metal (6), the second metal (7) and the third metal (8) are aluminum.
